Europäisches Patentamt

European Patent Office

Office européen des brevets

(11) Publication number: **0 100 501**
**B1**

# EUROPEAN PATENT SPECIFICATION

(45) Date of publication of patent specification: **08.02.89**

(51) Int. Cl.⁴: **G 01 H 1/00, G 01 H 13/00**

(21) Application number: **83107244.2**

(22) Date of filing: **23.07.83**

(54) **Vibration sensor.**

(30) Priority: **28.07.82 JP 132732/82**
**14.10.82 JP 180726/82**
**14.10.82 JP 180736/82**

(43) Date of publication of application:
**15.02.84 Bulletin 84/07**

(45) Publication of the grant of the patent:
**08.02.89 Bulletin 89/06**

(84) Designated Contracting States:
**DE FR GB**

(56) References cited:
**FR-A-2 441 959**
**FR-A-2 441 960**
**NL-A-7 807 172**
**US-A-2 769 867**

(73) Proprietor: **Matsushita Electric Industrial Co., Ltd.**
**1006, Oaza Kadoma**
**Kadoma-shi Osaka-fu, 571 (JP)**

(72) Inventor: **Fukada, Tetsuji**
**21-5-207, Suehiro-cho**
**Suita-shi Osaka-fu (JP)**
Inventor: **Ise, Yukihiko**
**10-27, Miyayama-cho 3-chome**
**Toyonaka-shi Osaka-fu (JP)**

(74) Representative: **Eisenführ & Speiser**
**Martinistrasse 24**
**D-2800 Bremen 1 (DE)**

## Description

Background of the invention

The present invention relates to a vibration sensor for sensing external vibrations in vibrating members and more particularly, to a resonance type vibration sensor and an acceleration sensor which are excellent in detection sensitivity at a predetermined frequency.

Conventionally, rectangular bimorph piezoelectric vibrators of a bending vibration mode, having a cantilever configuration, in which the resonance frequencies are arranged to coincide with natural frequencies of vibrating members so that the detection sensitivity is improved as compared with non-resonance type piezoelectric vibrators, and disk-like bimorph piezoelectric vibrators in which peripheral portions of the piezoelectric vibrators are fixedly supported through utilization of a surface bonding mode of the disks have been widely employed in vibration sensors for detecting elastic vibrations in the vibrating members. Such known rectangular or disk-like piezoelectric vibrators have the advantage that the piezoelectric elements can be manufactured accurately because of their simple shapes and their vibration modes can be easily analyzed and handled.

However, the known piezoelectric vibrators have the disadvantage that a portion of each of the piezoelectric vibrators must be stably clamped in order to stabilize their resonance frequencies, and supporting members made of metals, etc. for fixedly supporting the portion of each of the piezoelectric vibrators are displaced due to stresses produced mechanically or for various causes such as temperature variations, etc. Thus, it is difficult to fixedly support the portion of each of the piezoelectric vibrators. Furthermore, the known piezoelectric vibrators have the disadvantage that, since their resonance frequencies vary widely due to dimensional errors produced in machining or inaccurate assembly of their components during manufacturing processes thereof, adjustments for setting the known piezoelectric vibrators at the predetermined resonance frequencies are required to be made. Accordingly, in the case of the known rectangular bimorph piezoelectric vibrators, lengths of the vibrating portions are properly adjusted through cutting, grinding, etc. In the case of the known disk-like bimorph piezoelectric vibrators, the above described adjustments are required to be made by replacing the supporting members, etc. Thus, in both of the prior art rectangular and disk-like bimorph piezoelectric vibrators, the adjustments for setting them at the predetermined resonance frequencies are complicated and considerably troublesome. Furthermore, the prior art rectangular and disk-like bimorph piezoelectric vibrators have been disadvantageous in that it is difficult to perform the manufacturing operations since clamping conditions of the piezoelectric vibrators vary in accordance with the clamping forces of the supporting members, with the result that the piezoelectric elements are damaged in the case where the clamping forces of the supporting members are too large.

From NL—A—78 07 172 a vibrator for producing acoustic output signals from a driving voltage is known, and the vibrator is a rectangular bimorph vibrator of a cantilever configuration having a clamped end. Such vibrators have the disadvantage of unsatisfactory clamping conditions at the clamped end, thereby resulting in unstable operation of the vibrator, which could not be tolerated in a selective vibration sensor for sensing external vibration.

Accordingly, it is an object of the present invention to provide a vibration sensor for sensing external vibration which has stable resonance properties and which is simple in structure, highly reliable in actual use and suitable for mass production at low cost.

A vibration sensor solving the object of the present invention comprises: a piezoelectric vibrator, including first and second plate-like elements, at least one of which comprises a plate-like piezoelectric element, bonded to each other at confronting faces thereof; said first and second plate-like elements having a common polarization axis aligned in a direction perpendicular to the confronting faces thereof; said piezoelectric vibrator having a bending vibrator portion, integrally formed at said first and second plate-like elements and having a supporting portion peripherally of said bending vibrator portion; and means for fixedly supporting said supporting portion so that only said bending vibrator portion receives strain and is deflected in response to the external vibration, and said one end of said bending portion is stably fixed.

In accordance with the present invention, since the vibrator of the bending vibration mode is locally provided in the piezoelectric vibrator, the portion of the piezoelectric vibrator, disposed peripherally of the vibrator of the bending vibration mode, can be clamped more securely than those of the conventional piezoelectric vibrators of the centilever configurations, thus stabilizing the resonance frequency of the vibrator of the bending vibration mode.

Brief description of the drawings

These and other objects and features of the present invention will become apparent from the foregoing description taken in conjunction with the preferred embodiment thereof with reference to the accompanying drawings, in which:

Figs. 1(a), 1(b) and 1(c) are a top plan view, a cross-sectional view and a bottom plan view of a main portion of a vibration sensor according to a first embodiment of the present invention, respectively;

Figs. 2(a) and 2(b) are an exploded perspective view and a cross-sectional view of the vibration sensor of Fig. 1(a), respectively;

Figs. 3(a), 3(b) and 3(c) are a top plan view, a cross-sectional view and a bottom plan view of a main portion of a vibration sensor according to a second embodiment of the present invention, respectively;

Figs. 4(a), 4(b) and 4(c) are a top plan view, a cross-sectional view and a bottom plan view of a main portion of a vibration sensor according to a third embodiment of the present invention, respectively;

Fig. 5(a) is a perspective view of a rectangular cantilever type vibrator of a bending vibration mode; and

Fig. 5(b) is a graph explanatory of surface strain factors against lengths of a vibrating portion of the vibrator of Fig. 5(a).

Before the description of the present invention proceeds, it is to be noted that like parts are designated by like reference numerals throughout several views of the accompanying drawings.

Detailed description of the drawings

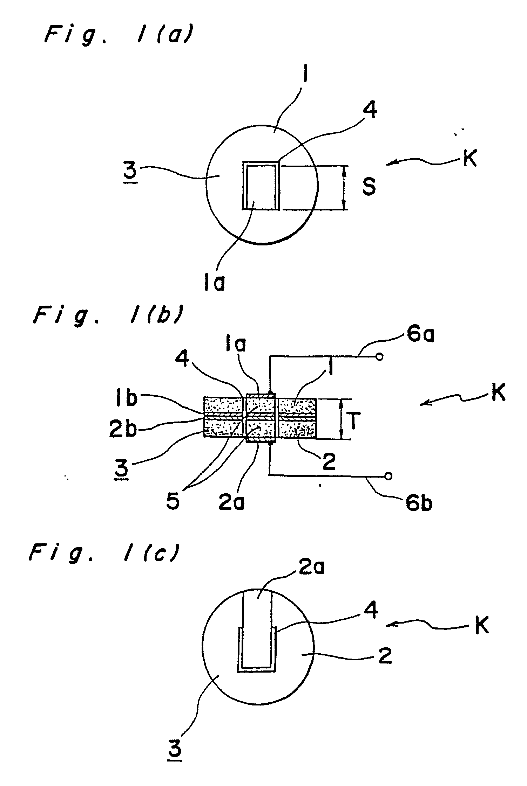

Referring now to the drawings, there is shown in Figs. 1(a) to 1(c), a vibration sensor K according to a first embodiment of the present invention. As shown in Fig. 1(b), the vibration sensor K includes a pair of disk-like piezoelectric elements 1 and 2 which are bonded to each other by a pair of sufficiently thin inner electrodes 1b and 2b so as to be electrically connected to each other such that the piezoelectric elements 1 and 2 bonded to each other constitute a bonded piezoelectric vibrator 3, with the inner electrodes 1b and 2b being provided on inner faces of the piezoelectric elements 1 and 2, respectively. The bonded piezoelectric vibrator 3 has a U-shaped slit 4 formed at a central portion thereof by a laser processing machine, etc. and extending therethrough. A rectangular upper electrode 1a is provided on an outer face of the piezoelectric element 1 remote from the inner electrode 1b so as to be enclosed by the slit 4. Meanwhile, a substantially rectangular lower electrode 2a is provided on an outer face of the piezoelectric element 2 remote from the inner electrode 2b so as to extend linearly and continuously from a portion enclosed by the slit 4 to a peripheral edge portion of the piezoelectric element 2. Namely, the bonded piezoelectric vibrator 3 has the upper electrode 1a and the lower electrode 2a provided on upper and lower faces thereof, respectively.

When a peripheral portion of the bonded piezoelectric vibrator 3, extending from portions disposed peripherally of the slit 4 to a peripheral edge of the bonded piezoelectric vibrator 3, is supported, as a supported portion, by supporting members, a rectangular portion of the bonded piezoelectric vibrator 3, enclosed by the slit 4, functions as a so-called cantilever type vibrator 5 of a bending vibration mode. An output voltage generated through vibration of the vibrator 5 of the bending vibration mode is applied between the upper electrode 1a and the lower electrode 2a of the bonded piezoelectric vibrator 3 and is further taken out by lead wires 6a and 6b which are respectively, connected to the upper electrode 1a and the lower electrode 2a.

Assuming that the vibrator 5 of the bending vibration mode has a thickness T and a length S, a resonance frequency Fr of the vibrator 5 is proportional to a value of $T/S^2$. Accordingly, the vibrator 5 can be set at a predetermined resonance frequency by properly determining values of the thickness T and the length S.

In the above described arrangement of the vibration sensor K, since the vibrator 5 of the bending vibration mode is locally provided in the bonded piezoelectric vibrator 3, variations of the resonance frequency of the vibrator 5 of the bending vibration mode, resulting from changes in clamping conditions of the supported portion of the bonded piezoelectric vibrator 3, are kept minimal, so that the resonance frequency of the vibrator 5 of the bending vibration mode is made stable. Namely, variations of the resonance frequency of the vibrator 5 of the bending vibration mode, resulting from, for example, displacement of the supported portion of the bonded piezoelectric vibrator 3 due to stresses produced mechanically or for other causes such as temperature variations, etc., are kept minimal, so that the resonance frequency of the vibrator 5 of the bending vibration mode is made stable. Meanwhile, in the vibration sensor K, since the supporting members are not required to be positioned so accurately, the vibration sensor K can be assembled easily. Furthermore, since the vibrator 5 of the bending vibration mode is locally provided in the bonded piezoelectric vibrator 3, the bonded piezoelectric vibrator 3 is not formed, at the upper and lower faces, with projections which are provided in conventional cantilever type vibrators, so that damage to the vibration sensor K through improper handling thereof can be advantageously eliminated. Moreover, since adjustments for setting the vibrator 5 of the bending vibration mode at the predetermined resonance frequency can be easily made by trimming the vibrating portion with a laser processing machine without the need for partially grinding the vibrating portions in conventional vibration sensors, the vibration sensor K is suitable for mass production.

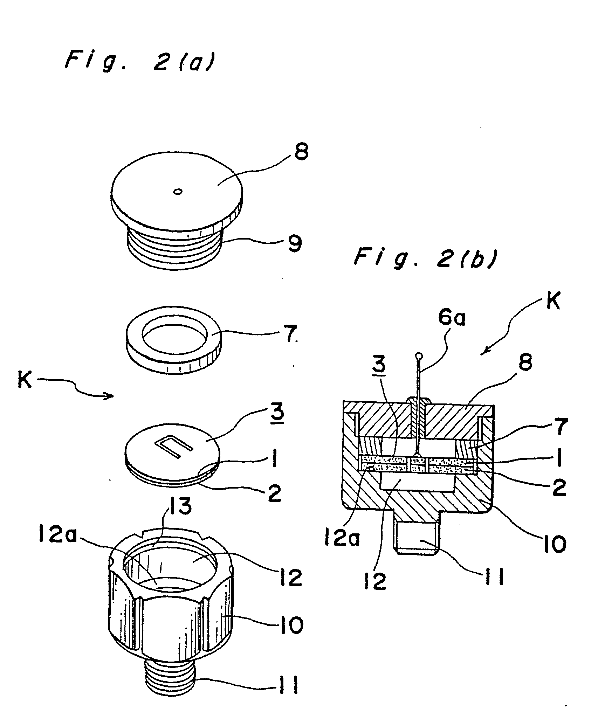

Referring now to Figs. 2(a) and 2(b), the vibration sensor K includes a metallic supporting member 10 for supporting the bonded piezoelectric vibrator 3, which has a male screw portion 11 formed at one end thereof and threadingly inserted into a vibrating member, a stepped hole 12 formed at the other end thereof remote from the male screw portion 11, and a female screw portion 13 formed at an inlet of the stepped hole 12. The vibration sensor K further includes an annular supporting member 7 and a clamping member 8 having a male screw portion 9 engageable with the female screw portion 13 of the supporting member 10. After the bonded piezoelectric vibrator 3 has been inserted into the stepped hole 12 of the supporting member 10 such that the lower face of the bonded piezoelectric vibrator 3 is brought into contact with an annular intermediate bottom 12a of the stepped hole 12, the supporting member 7 is clamped onto an annular peripheral portion of the upper face of the bonded piezoelectric vibrator 3 by the clamping member 8 through engagement of the male screw portion 9 of the clamping member 8 with the female screw portion 13 of the supporting member 10, whereby the bonded piezoelectric vibrator 3 is fixedly supported. Since the lower electrode 2a provided on the lower face of the bonded piezoelectric vibrator 3 is fixedly supported by the supporting member 10, the lower electrode 2a is electrically connected to the supporting member 10 and thus, the supporting member 10 is used as one terminal for taking out the output voltage of the vibrator 5 of the bending vibration mode. The lead wire 6a extending from the upper electrode 1a of the bonded piezoelectric vibrator 3 is used as the other terminal for the vibrator 5 of the bending vibration mode.

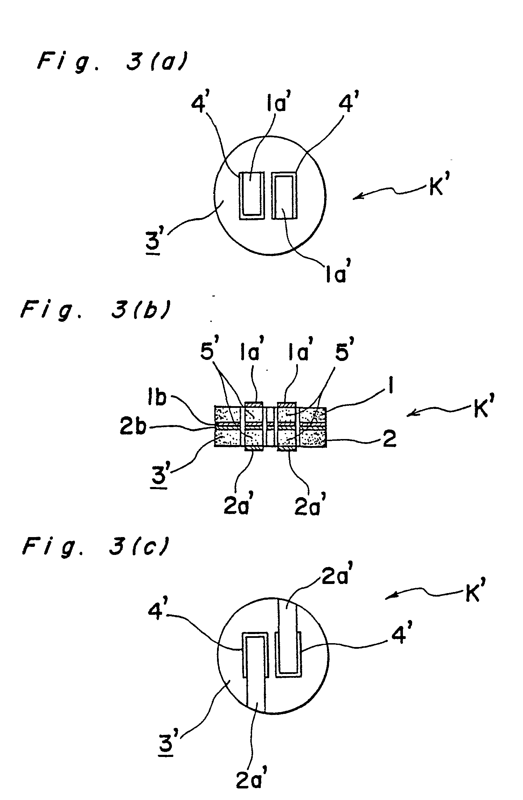

Referring to Figs. 3 (a) to 3(c), there is shown a vibration sensor K' according to a second embodiment of the present invention. The vibration sensor K' includes a bonded piezoelectric vibrator 3' having a pair of U-shaped slits 6' formed radially symmetrically in a side by side relationship with respect to each other such that a pair of rectangular vibrators 5' of a bending vibration mode are enclosed by the slits 4', respectively. The vibration sensor K' further includes a pair of upper electrodes 1a' and a pair of lower electrodes 2a' which are, respectively, provided on upper and lower faces of the bonded piezoelectric vibrator 3' in the same manner as described in the vibration sensor K. In the vibration sensor K', when a resonance frequency of one vibrator 5' of the bending vibration mode is made equal to that of the other vibrator 5'; its detection sensitivity at a predetermined vibration frequency can be enhanced. Meanwhile, when the vibrators 5' of the bending vibration mode are, respectively, set at different resonance frequencies correlated to each other, its detection accuracy is improved.

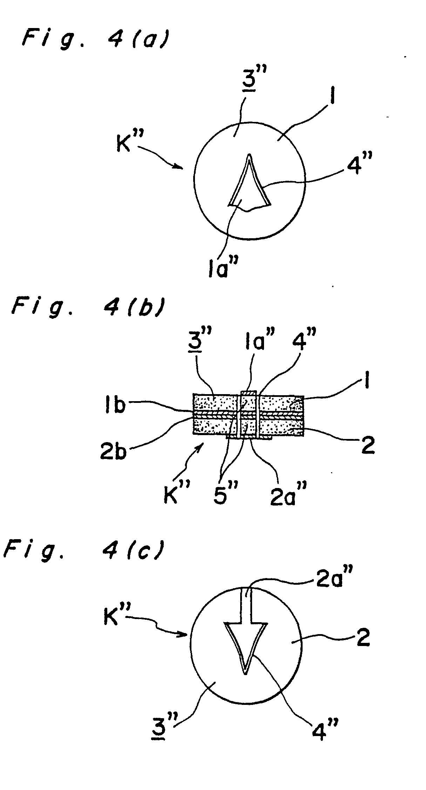

Referring to Figs. 4(a) to 4(c), there is shown a vibration sensor K'' according to a third embodiment of the present invention. The vibration sensor K'' includes a bonded piezoelectric vibrator 3'' having a substantially triangular slit 4'' formed at a central portion thereof such that a vibrator 5'' of a bending vibration mode, enclosed by the slit 4'', is formed into a triangular shape. The vibration sensor K'' further includes a triangular upper electrode 1a'' and an arrow-shaped lower electrode 2a'' which are, respectively, provided on upper and lower faces of the bonded piezoelectric vibrator 3'' in the same manner as described in the vibration sensor K.

Since other constructions of the vibration sensors K' and K'' are similar to those of the vibration sensor K, description thereof is abbreviated for brevity.

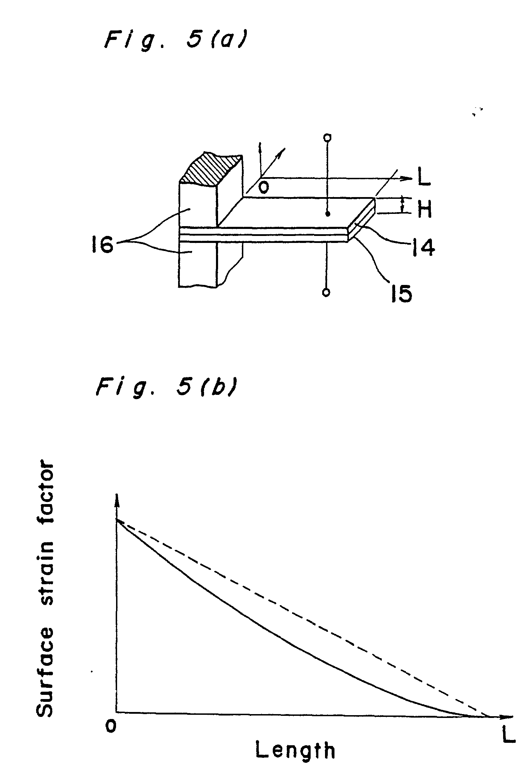

Hereinbelow, a rectangular vibrator of a bending vibration mode having a cantilever configuration, will be described with reference to Figs. 5(a) and 5(b). As shown in Fig. 5(a), the vibrator includes a pair of rectangular piezoelectric elements 14 and 15 which are bonded to each other and are fixedly supported, at one end portion thereof, by a pair of rectangular supporting members 16 such that one side face of each of the supporting members 16 is flush with one end of the vibrator. Assuming that a length L of a vibrating portion of the vibrator for detecting vibrations of a vibrating member is measured from the other side face of each of the supporting members 16 remote from the one end of the vibrator towards the other end of the vibrator and the vibrating portion has a thickness H, surface strain factors at the vibrating portion are illustrated by the curved solid line in Fig. 5(b). Meanwhile, the linear broken line in Fig. 5(b) approximately illustrates the surface strain factors at the vibration portion by connecting opposite ends of the curved solid line in Fig. 5(b). It will be readily understood from Fig. 5(b) that the surface strain factors at the vibration portion of the vibrator of the bending vibration mode reach a maximum value at the time when the length L is zero, namely, at the starting-point of the length L. Consequently, when an extremely large force is applied to the vibrator, a portion of the vibrator, adjacent to the supporting members 16, is most readily damaged.

Accordingly, in the present invention, it is so arranged that the slit 4'' of the vibration sensor K'' is formed on the bonded piezoelectric vibrator 3'' by the use of a laser processing machine, etc. such that a vibrating portion of the vibrator 5'' of the bending vibration mode for detecting vibrations of a vibrating member has an area proportional to the surface strain factors shown in Fig. 5(b). Namely, since a portion of the vibrating portion of the vibrator 5'', which has a large surface strain factor, is increased in area while another portion of the vibrating portion of the vibrator 5'', which has a small surface strain factor, is decreased in area, the vibrating portion of the vibrator 5'' has a uniform surface strain factor. Accordingly, when a force is applied to a whole of the vibrating portion, a portion of the vibrating portion, adjacent to the supporting members, can be more effectively prevented from being damaged than those of the conventional rectangular vibrators of the bending vibration mode. Furthermore, since the vibrating portion of the vibrator 5'' has the uniform surface strain factor, operational characteristics of the vibration sensor K'' can be kept stable for a long time.

Meanwhile, numerical control units are widely employed in machine tools such as a laser processing machine, etc., but, in some cases, enable only linear cutting and cutting of circular interpolation, the consequence of which is that considerably complicated programs are required for machining arbitrary curves. In such cases, when the vibrator of the bending vibration mode is so manufactured as to have a surface strain factor corresponding to that shown in the broken line in Fig. 5(b), the surface strain factor of the vibrator of the bending vibration mode can be made more uniform than those of the conventional vibrators of the bending vibration mode.

Moreover, when it is so arranged that, in order to increase mechanical strength of the bonded piezoelectric vibrator, the bonded piezoelectric vibrator is constituted by a plate-like piezoelectric element and a metallic plate each having a polarization axis aligned in a direction of thickness thereof or by a pair of plate-like piezoelectric elements each having a polarization axis aligned in a direction of thickness thereof in which direction a metallic plate is interposed therebetween, the same effect as described above can be obtained.

In the case where the plate-like piezoelectric element is bonded to the mating metallic plate or the mating plate-like piezoelectric element by the use of organic adhesive in the bonded piezoelectric vibrator, the organic adhesive is carbonized through irradiation of laser beam thereto, so that the carbonized organic adhesive is caused to adhere to opposite wall faces of the slit, thereby incurring a high possibility that the inner electrodes disposed at the bonding faces of the bonded piezoelectric vibrator are short-circuited to the respective upper and lower electrodes of the bonded piezoelectric vibrator. In order to eliminate such a phenomenon, for example, glassy adhesive can be used as inorganic adhesive for bonding the plate-like piezoelectric element to the mating metallic plate or the mating plate-like piezoelectric element. The glassy adhesive has such advantages that it is not carbonized even in a molten state in contrast with the organic adhesive, with the result that the above-described short-circuit between the electrodes of the bonded piezoelectric vibrator does not take place. Furthermore, in place of the glassy adhesive, a thin film of solder can be employed for soldering the inner electrodes to each other. Moreover, when it is so arranged that the bonding faces of either one of the plate-like piezoelectric element and the metallic plate or either one of the plate-like piezoelectric elements, and the other one of the plate-like piezoelectric element and the metallic plate or the other one of the plate-like piezoelectric elements are respectively, formed as an electrode on which gold is deposited, and as an electrode which is obtained by depositing silicon on a surface of gold such that eutectic bonding of gold and silicon takes place at temperatures of a few hundred degrees centigrade, whereby the plate-like piezoelectric element can be bonded to the mating metallic plate or the mating plate-like piezoelectric element.

As is clear from the foregoing description, in accordance with the present invention, since the vibrator of the bending vibration mode is locally provided in the bonded piezoelectric vibrator, the portion of the piezoelectric vibrator, disposed peripherally of the vibrator of the bending vibration mode, can be clamped more securely than those of the conventional piezoelectric vibrators of the cantilever configuration, so that the resonance frequency of the vibrator of the bending vibration mode can be kept stable. Furthermore, in accordance with the present invention, the vibration sensor is made suitable for mass production.

Although the present invention has been fully described by way of example with reference to the accompanying drawings, it is to be noted here that various changes and modifications will be apparent to those skilled in the art. Therefore unless otherwise such changes and modifications depart from the scope of the present claims, they should be construed as included therein.

## Claims

1. A vibration sensor for sensing external vibration, comprising:

a piezoelectric vibrator (3, 3', 3''), including first and second plate-like elements (1, 2; 1', 2'; 1'', 2''), at least one of which comprises a plate-like piezoelectric element, bonded to each other at confronting faces thereof;

said first and second plate-like elements (1, 2; 1', 2'; 1'', 2'') having a common polarization axis aligned in a direction perpendicular to the confronting faces thereof;

said piezoelectric vibrator (3, 3', 3'') having a bending vibrator portion (5, 5', 5''), integrally formed at said first and second plate-like elements (1, 2; 1', 2'; 1'', 2'') and having a supporting portion peripherally of said bending vibrator portion (5, 5', 5''); and

means (7, 12a) for fixedly supporting said supporting portion so that only said bending vibrator portion (5, 5', 5'') receives strain and is deflected in response to the external vibration and said one end of said bending portion (5, 5', 5'') is stably fixed.

2. A vibration sensor as in claim 1, wherein the bending vibrator portion (5, 5') is integrally formed at the plate-like elements (1, 2; 1', 2') by a U-shaped slit (4, 4').

3. A vibration sensor as in claim 1, wherein the bending vibrator portion (5'') is integrally formed at the plate-like elements (1'', 2'') by a V-shaped slit (4'').

4. A vibration sensor as claimed in claim 2, wherein a plurality of vibrator portions (5') bending localized in said piezoelectric vibrator (3').

5. A vibration sensor as claimed in claim 1, wherein said bending vibrator portion (5'') is so formed as to have, in a longitudinal direction thereof, a uniform surface strain factor.

6. A vibration sensor as claimed in claim 1, wherein one of said first and second plate-like elements (1, 2) is a metallic plate.

7. A vibration sensor as claimed in claim 1, further including a metallic plate interposed between said first and second plate-like elements (1, 2) in the direction of thickness thereof, said second plate-like element comprising a second plate-like piezoelectric element.

8. A vibration sensor as claimed in claim 1, wherein said first and second plate-like elements (1, 2) are bonded to each other by one of inorganic adhesive, solder, and eutectic bonding of gold and silicon.

9. A vibration sensor as claimed in claim 6, wherein the other one of said first and second plate-like elements (1, 2) is bonded to said metallic plate by one of inorganic adhesive, solder, and eutectic bonding of gold and silicon.

10. A vibration sensor as claimed in claim 7, wherein said first and second plate-like elements (1, 2) are bonded to said metallic plate by one of inorganic adhesive, solder, and eutectic bonding of gold and silicon.

## Patentansprüche

1. Vibrationssensor zum Feststellen von externen Vibrationen, dadurch gekennzeichnet,

daß ein piezo-elektrischer Schwinger (3, 3', 3'') vorgesehen ist, der erste und zweite, plattenförmige Elemente (1, 2; 1', 2'; 1'', 2'') aufweist, von denen mindestens eines ein plattenförmiges piezo-elektrisches Element bildet, und die an ihren aneinanderliegenden Flächen miteinander verbunden sind;

daß die ersten und zweiten plattenförmigen Elemente (1, 2; 1', 2'; 1'', 2'') eine gemeinsame Polarisationsachse aufweisen, die rechtwinklig gegenüber den miteinander verbundenen Flächen ausgerichtet ist;

daß der piezo-elektrische Schwinger (3, 3', 3'') einen Biegeschwingerabschnitt (5, 5', 5'') aufweist, der integral an den ersten und zweiten plattenförmigen Elementen (1, 2; 1', 2'; 1'', 2'') angeformt ist und einen peripher zu dem Biegeabschnitt (5, 5', 5'') angeordneten Stützabschnitt aufweist; und

daß Mittel (7, 12a) zum Befestigen des Stützabschnittes in der Weise vorgesehen sind, daß nur der Biegeschwingerabschnitt (5, 5', 5'') belastet und entsprechend der externen Vibration gebogen wird, während das eine Ende des Biegeabschnittes (5, 5', 5'') stabil befestigt ist.

2. Vibrationssensor nach Anspruch 1, dadurch gekennzeichnet, daß der Biegeschwingerabschnitt (5, 5') an den plattenförmigen Elementen (1, 2; 1', 2') mittels eines U-förmigen Schlitzes (4, 4') integral angeformt ist.

3. Vibrationssensor nach Anspruch 1, dadurch gekennzeichnet, daß der Biegeschwingerabschnitt (5'') an den plattenförmigen Elementen (1'', 2'') mittels eines V-förmigen Schlitzes (4'') integral angeformt ist.

4. Vibrationssensor nach Anspruch 2, dadruch gekennzeichnet, daß der piezo-elektrische Schwinger (3') eine Mehrzahl von Biegeschwingerabschnitten (5') aufweist.

5. Vibrationssensor nach Anspruch 1, dadurch gekennzeichnet, daß der Biegeschwingerabschnitt (5'') derart geformt ist, daß er in seiner Längsrichtung einen gleichmäßigen Flächenspannungsfaktor aufweist.

6. Vibrationssensor nach Anspruch 1, dadurch gekennzeichnet, daß eine der ersten und zweiten plattenförmigen Elemente (1, 2) eine Metallplatte ist.

7. Vibrationssensor nach Anspruch 1, gekennzeichnet durch eine Metallplatte, die zwischen den ersten und zweiten plattenförmigen Elementen (1, 2) in deren Dickenrichtung angeordnet ist, und daß das zweite plattenförmige Element ein zweites plattenförmiges piezo-elektrisches Element enthält.

8. Vibrationssensor nach Anspruch 1, dadurch gekennzeichnet, daß die ersten und zweiten plattenförmigen Elemente (1, 2) durch einen inorganischen Kleber, durch Löten oder durch eutecktisches Verbinden von Gold und Silizium miteinander verbunden sind.

9. Vibrationssensor nach Anspruch 6, dadurch gekennzeichnet, daß die andere der ersten und zweiten plattenförmigen Elemente (1, 2) durch einen inorganischen Kleber, durch Löten oder durch eutecktisches Verbinden von Gold und Silizium mit der Metallplatte verbunden ist.

10. Vibrationssensor nach Anspruch 7, dadurch gekennzeichnet, daß die ersten und zweiten plattenförmigen Elemente (1, 2) durch einen inorganischen Kleber, durch Löten oder durch eutecktisches Verbinden von Gold und Silizium mit der Metallplatte verbunden sind.

## Revendications

1. Capteur de vibrations pour capter des vibrations externes, comprenant:

un vibreur piézoélectrique (3, 3', 3'') incluant un premier et un deuxième élément du genre plaque (1, 2; 1', 2'; 1'', 2''), dont au moins un comprend un élément piézoélectrique du genre plaque qui sont assemblés l'un à l'autre en des faces mutuellement en regard;

lesdits premier et deuxième élément du genre plaque (1, 2; 1', 2'; 1'', 2'') ayant un axe de polarisation commun aligné dans une direction perpendiculaire à leurs faces mutuellement en regard;

ledit vibreur piézoélectrique (3, 3', 3'') ayant une partie vibreur fléchissante (5, 5', 5'') formée d'un seul tenant sur lesdits premier et deuxième élément du genre plaque (1, 2; 1', 2'; 1'', 2'') et ayant une partie support à la périphérie de ladite partie vibreur fléchissante (5, 5', 5''); et

des moyens (7, 12a) pour supporter de manière fixe ladite partie-support de manière que seule ladite partie vibreur fléchissante (5, 5', 5'') reçoive de la contrainte et soit défléchie en réponse à la vibration externe, et que ladite première extrémité de ladite partie fléchissante (5, 5', 5'') soit fixée de manière stable.

2. Capteur de vibrations selon revendication 1,

dans lequel la partie vibreur fléchissante (5, 5') est formée intégralement sur les éléments du genre plaque (1, 2; 1', 2') par une fente en forme de U (4, 4').

3. Capteur de vibrations selon revendication 1,

dans lequel la partie vibreur fléchissante (5'') est formée intégralement sur les éléments du genre plaque (1'', 2'') par une fente en forme de V (4'').

4. Capteur de vibrations selon revendication 2, dans lequel plusieurs parties vibrantes fléchissantes (5') sont situées dans ledit vibreur piézoélectrique (3').

5. Capteur de vibrations selon revendication 1, dans lequel ladite partie vibreur fléchissante (5'') est formée de manière à posséder, dans sa direction longitudinale, un facteur de contrainte de surface uniforme.

6. Capteur de vibrations selon revendication 1, dans lequel l'un desdits premier et deuxième élément du genre plaque (1, 2) est une plaque métallique.

7. Capteur de vibrations selon revendication 1, comprenant en outre une plaque métallique interposée entre lesdits premier et deuxième élément du genre plaque (1, 2), dans la direction de leur épaisseur, ledit deuxième élément du genre plaque comprenant un deuxième élément piézoélectrique du genre plaque.

8. Capteur de vibrations selon revendication 1, dans lequel lesdits premier et deuxième élément du genre plaque (1, 2) sont assemblés l'un à l'autre par l'un des moyens suivantes: adhésif inorganique, soudure, et liant eutectique d'or et de silicium.

9. Capteur de vibrations selon revendication 6, dans lequel l'autre desdits premier et deuxième élément du genre plaque (1, 2) et lié à ladite plaque métallique par l'un des moyens suivants: adhésif inorganique, soudure et liant eutectique d'or et de silicium.

10. Capteur de vibrations selon revendication 7, dans lequel lesdits premier et deuxième élément du genre plaque (1, 2) sont liés à ladite plaque métallique par l'un des moyens suivants: adhésif inorganique, soudure et liant eutectique d'or et de silicium.

*Fig. 1(a)*

*Fig. 1(b)*

*Fig. 1(c)*

1

Fig. 2(a)

Fig. 2(b)

**Fig. 3(a)**

**Fig. 3(b)**

**Fig. 3(c)**

Fig. 4(a)

Fig. 4(b)

Fig. 4(c)

*Fig. 5(a)*

*Fig. 5(b)*